# EUROPEAN PATENT SPECIFICATION

(11) **EP 4 703 667 B1**
(45) Date of publication and mention of the grant of the patent: **02.09.2026**
(21) Application number: 25190742.4
(22) Date of filing: 21.07.2025
(51) Int. Cl.: F28D 15/02, B23K 1/00, B23K 26/20

(54) **THREE-DIMENSIONAL HEAT CONDUCTING STRUCTURE AND MANUFACTURING METHOD THEREOF**
DREIDIMENSIONALE WÄRMELEITENDE STRUKTUR UND HERSTELLUNGSVERFAHREN DAFÜR
STRUCTURE TRIDIMENSIONNELLE CONDUCTRICE DE CHALEUR ET SON PROCÉDÉ DE FABRICATION

(30) Priority: 30.08.2024 US 202463689272 P
(43) Date of publication of application: 04.03.2026
(73) Proprietor: Purple Cloud Development Pte. Ltd., Singapore 128424 (SG)
(72) Inventor: Liu, Lei Lei, Hui Zhou City (CN); Zhang, Xiong, Hui Zhou City (CN); Huang, Jian-Jia, Taipei City (TW)
(74) Representative: Grünecker Patent- und Rechtsanwälte PartG mbB

(56) References cited:
- EP-A1- 4 502 523
- CN-A- 107 484 386
- US-A1- 2016 348 985

## Description

### FIELD OF THE INVENTION

The present disclosure relates to a heat conducting device, and in particularly to a three-dimensional heat conducting structure and its manufacturing method.

### BACKGROUND

In a conventional heat conducting structure, the heat pipe is combined with the vapor chamber using conventional soldering techniques. However, by doing so, the melted solder may overflow to the undesired combining place as well as other positions such as the interior of vapor chamber, influencing the combined effect of the soldering and resulting in appearance defects and a drop in production yield.

As the convention soldering techniques in the related art, it discloses a support ring that can be placed on either the heat pipe or a hole of the vapor chamber. Furthermore, a solder is arranged around the top of the support ring after the heat pipe and vapor chamber have been joined. A soldering process would then be applied to secure a strong connection via the support ring, which provides a supporting force for the heat pipe and vapor chamber combination.

However, when the heat pipe is placed into the through hole of the vapor chamber, gaps may form between the heat pipe and a rim that surrounds the through hole. The melted welding ring and its solder have a high fluidity due to their relatively low melting points. As a result, the holes allow the melted welding ring and its solder to flow into the vapor chamber.

A heat pipe according to the preamble of claim 1 is disclosed in US 2016/348985.

### SUMMARY

The invention is as defined in the appended claims. The present disclosure presents a solution to the concerns outlined above. The heat pipe and the vapor chamber are first joined by a laser welding technique, eliminating gaps between the heat pipe and the edge of the vapor chamber hole. After the welding ring is placed on the outer surface of the heat pipe to enclose a rim that is formed around the periphery of the through hole, a soldering process is used to ensure a secure connection between the heat pipe and the vapor chamber. As there is no or little gaps between the heat pipe and the edge of the vapor chamber hole, it could obstruct the melted welding ring and its solder from entering the vapor chamber.

To achieve the abovementioned advantages, the present disclosure provides a three three-dimensional heat conducting structure that includes a vapor chamber having a casing and at least one through hole that is formed on the casing and is in fluid communication with an interior of the casing, at least one heat pipe having an open end that is inserted into the through hole and is in fluid communication with the interior of the casing, and a rim that is formed around a periphery of the through hole and is protruded from an outer surface of the vapor chamber, wherein gaps between the rim and the heat pipe are sealed by laser welding, and a welding ring is soldered to further secure the connection between the heat pipe and the vapor chamber.

In some embodiments, the vapor chamber further includes a capillary structure and a cooling fluid that are arranged in the interior of the casing.

In some embodiments, the welding ring is made of metal, alloy or heat-resistant non-metal material.

In some embodiments, the soldered welding ring stays between the vapor chamber and the heat pipe without overflowing to the interior of the vapor chamber.

In some embodiments, the welding ring encloses the rim before being soldered.

In some embodiments, a secure bond is formed between the rim the heat pipe after the laser welding is applied solely on the gaps between the heat pipe and the rim.

According to one embodiment of the present disclosure, a manufacturing method of a three-dimensional heat conducting structure includes forming a vapor chamber that includes a casing with at least one through hole, forming at least one heat pipe that has an open end, and inserting the open end into the through hole so that the heat pipe and vapor chamber are in fluid communication, applying laser welding process to gaps between the heat pipe and a rim, placing a welding ring on a joint position of the heat pipe and the vapor chamber so that the welding ring can enclose the rim, and applying a welding process to solder the welding ring to secure the connection between the heat pipe and the vapor chamber.

### BRIEF DESCRIPTION OF THE DRAWINGS

Aspects of the present disclosure can be understood from the following detailed description when read with the accompanying Figures. It is noted that, in accordance with the standard practice in the industry, various features are not drawn to scale. In fact, the dimensions of the various features may be increased or reduced for clarity of discussion.
FIG. 1 shows a flowchart of a method for forming a three-dimensional heat conducting structure.
FIG. 2 - 6 show a manufacturing process for forming the three-dimensional heat conducting structure.
FIG. 3A is a cross-sectional view showing the gaps in FIG. 3 in relative detail.
FIG. 4A is an enlarged square portion of FIG. 4.

### DETAILED DESCRIPTION

Detailed descriptions and technical contents of the present invention are illustrated below in conjunction with the accompanying drawings. However, it is to be understood that the descriptions and the accompanying drawings disclosed herein are merely illustrative and exemplary and not intended to limit the scope of the present invention.

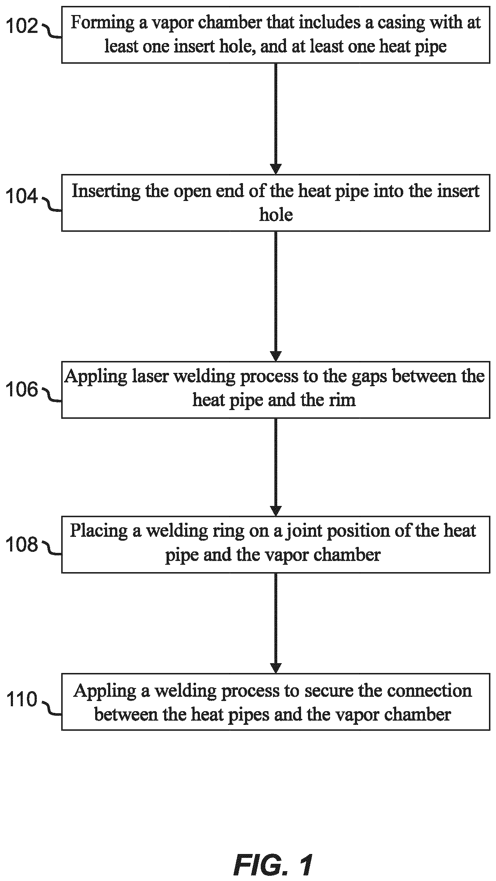

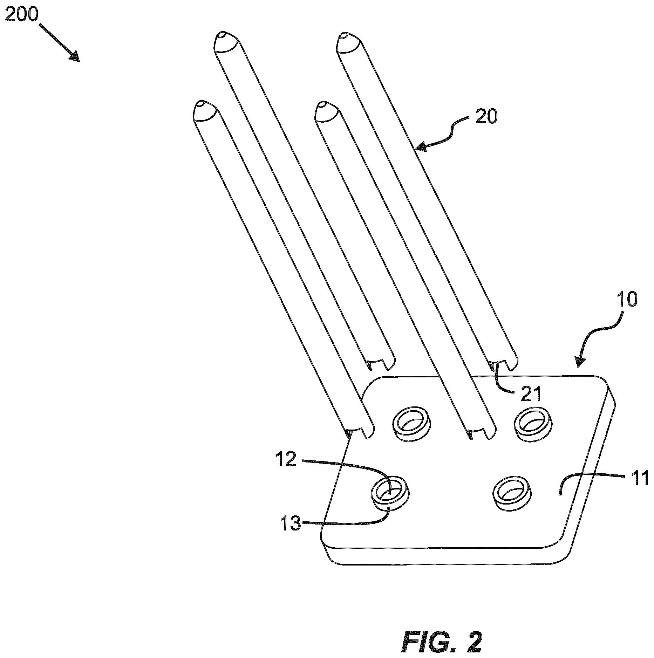

FIG. 1 is a flowchart of an exemplary method for forming a three-dimensional heat conducting structure 200, according to some embodiments of the present disclosure. FIGS. 2 - 6 show an exemplary manufacturing process for forming the three-dimensional heat conducting structure 200.

Referring to FIG. 1, the method starts at step 102, in which a vapor chamber 10 and at least one heat pipe 20 are formed as shown in FIG.2. The heat conducting structure 200 in FIG.2 includes a vapor chamber 10 and at least one heat pipe 20. The vapor chamber 10 includes a casing 11, and at least one through hole 12 that is formed on the casing 11 and is communicated with the interior of the casing 11. At step 102, in one embodiment, the rim 13 is formed around the periphery of the through hole 12 and is protruded from an outer surface of the vapor chamber 10. In another embodiment, the rim 13 can be welded to the surface of the vapor chamber 10, surrounding the periphery of the though hole 12. The rim 13 is designed to improve the precision and alignment of inserting the heat pipe 20 into the through hole 12 of the vapor chamber 10. The rim 13 ensures an optimal fit and combination between the heat pipe 20 and the vapor chamber 10 by providing a better positioning effect. This enhanced positioning leads to an improved mechanical stability and thermal performance, which ultimately increases the efficiency and yield of the three-dimensional heat-conducting structure 200. The precise alignment enabled by the rim 13 contributes to a better thermal conductivity, reducing thermal resistance and optimizing heat transfer between the heat pipe 20 and the vapor chamber 10. In one embodiment, the vapor chamber 10 further includes a capillary structure (not shown) and a cooling fluid (not shown) that are arranged in the interior of the casing 11.

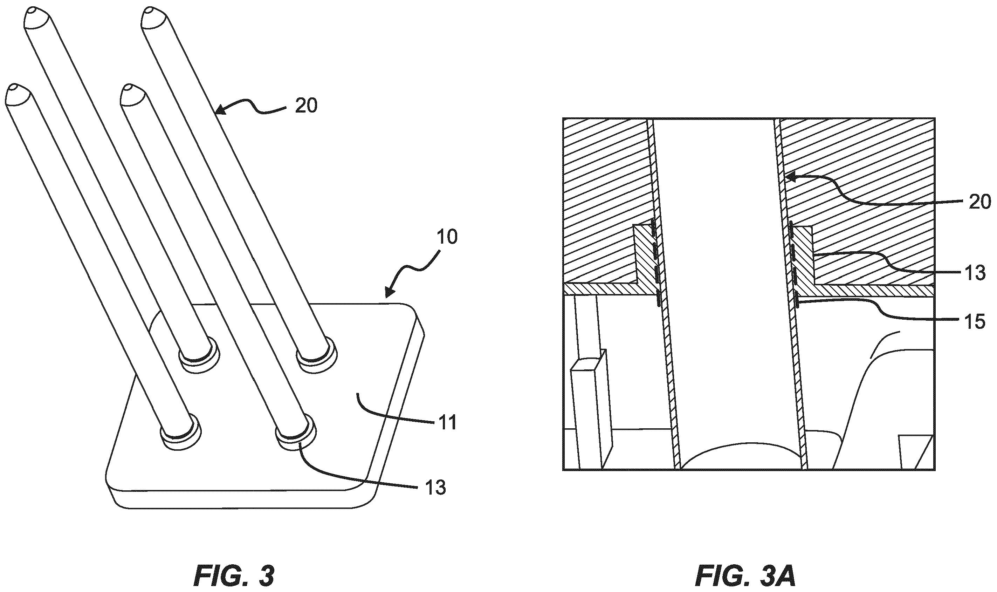

The method 100 proceeds to the step 104, in which the heat pipe 20 is placed into the through hole 12 on the vapor chamber 10 as shown in FIG. 3. The heat pipe 20 in FIG.3 is a hallow metal pipe. The heat pipe 20 has an open end 21 that is inserted into the through hole 12 and in communication with the interior of the casing 11. In an embodiment, the number of through holes 12 is equal to the number of the heat pipes 20. In FIG. 3A, minor gaps 15 are evident between the heat pipe 20 and the assembly rim 13, as indicated by the dotted lines. If these gaps 15 are not properly sealed, there is a risk that the welded solder may flow into the casing 11 interior. This unwanted infiltration of solder could compromise the structural integrity, reduce thermal efficiency, and lead to system malfunctions. To prevent this, it is important to take appropriate measures to effectively seal the gaps 15, such as applying laser welding.

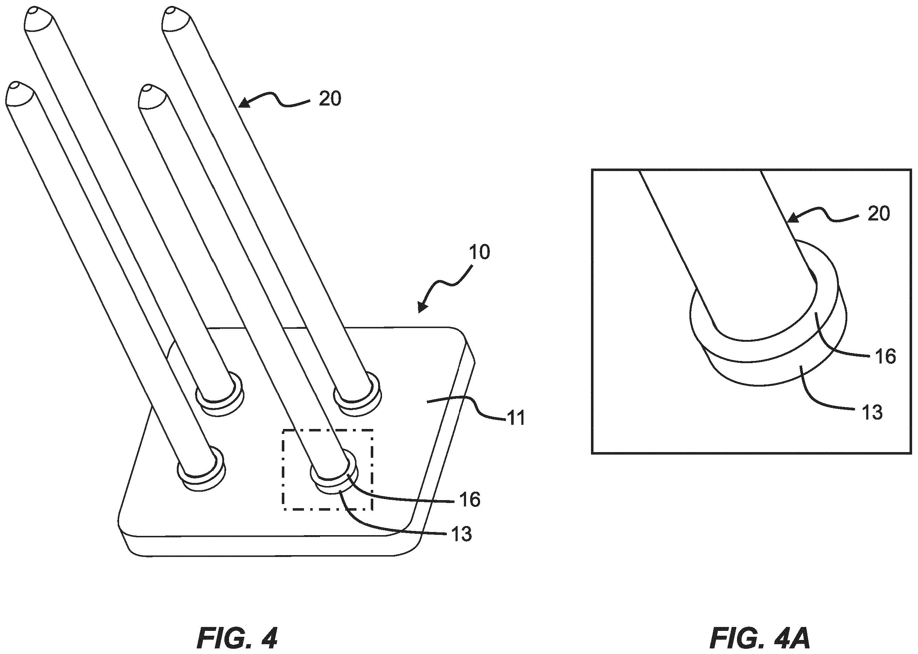

The method proceeds to the step 106, in which laser welding process is applied to the gaps 15 between the heat pipe 20 and the rim 13 as shown in FIG. 4. The gaps 15 between the heat pipe 20 and the rim 13 are sealed as shown in FIG. 4A. During this step, the laser beam is directed precisely at the gaps 15, effectively sealing them to ensure a secure bond 16 between the components. The high precision offered by laser welding allows for the creation of very specific and focused welds, which significantly reduces the possibility of heat spreading to unintended areas. Accordingly, the laser beam does not physically touch or affect any other parts of the heat-conducting structure, focusing solely on the gaps 15 between the heat pipe 20 and the rim 13. This localized application of heat minimizes distortion, ensuring the overall structural integrity and performance of the heat-conducting assembly. Further, the laser welding process creates a strong and durable seal that enhances the thermal efficiency and reliability of the assembly, preventing any unwanted material from entering or disrupting the internal components of the device.

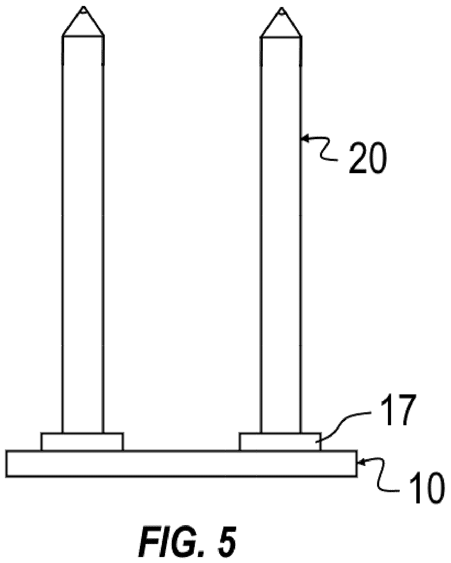

The method proceeds to the step 108, in which a solid welding ring 17 is placed on a joint position between the heat pipe 20 and the vapor chamber 10, as shown in FIG. 5, which provides a cross-sectional view of the heat conducting structure 200. In FIG. 5, the welding ring 17 is sheathed on an outer surface of the heat pipe 20 and disposed on the casing 11 so that the welding ring 17 encloses the rim 13. The welding ring 17 is positioned above the sealed gaps 15 and is in contact with an outer surface of the rim 13. In one embodiment, the welding ring 17 is primarily made of metal (e.g. copper). However, the embodiment is not limited thereto. In other embodiments, the welding ring 17 can be made of alloy or heat resistant non-metal. In one embodiment, the welding ring 17 is used as a solder. In other embodiments, the solder can also be a welding strip or a welding paste.

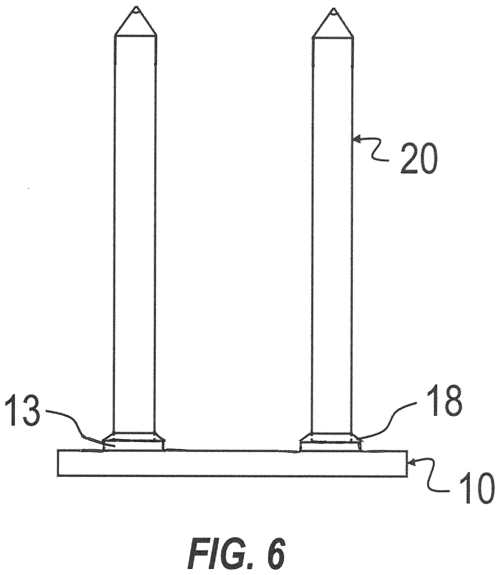

The method proceeds to the step 110, in which a welding process is applied to solder the welding ring 17 to secure the connection between the heat pipe 20 and the vapor chamber 10, as shown in FIG. 6, which provides a cross-sectional view of the heat conducting structure 200. In FIG.6, the welding ring 17 is soldered to secure the heat pipe 20 onto the vapor chamber 10. Because the laser welding was applied to seal the gaps 15 between the heat pipe 20 and the rim 13 in the previous steps, the soldered welding ring 18 will not overflow to the interior of the vapor chamber 10. By following the described process above, the spaces between the heat pipe 20 and the vapor chamber 10 can be tightly sealed, allowing the heat pipe 20 to conduct heat quickly and uniformly.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the of the present disclosure. Of course, the disclosed embodiments are merely exemplary embodiments and that various modifications can be made without departing from the scope of the disclosure. Further, it should be understood that various aspects of the embodiment are not mutually exclusive of each other and can be combined as desired by a person of ordinary skill in the art as a matter of design choices.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A three-dimensional heat conducting structure (200), comprising:
a vapor chamber (10) having a casing (11) and at least one through hole (12) that is formed on the casing (11) and is in fluid communication with an interior of the casing (11);
at least one heat pipe (20) having an open end (21) that is inserted into the through hole (12) and is in fluid communication with the interior of the casing (11); and
a rim (13) that is disposed on an outer surface of the vapor chamber (10), wherein
a welding ring (17) is soldered to further secure the connection between the heat pipe (20) and the vapor chamber (10), the three-dimensional heat conducting structure being **characterized in that** gaps (15) between the rim (13) and the heat pipe (20) are sealed by laser welding.

2. The three-dimensional heat conducting structure (200) according to claim 1, wherein the vapor chamber (10) further includes a capillary structure and a cooling fluid that are arranged in the interior of the casing (11).

3. The three-dimensional heat conducting structure (200) according to claim 1 or 2, wherein the welding ring (17) is made of metal, alloy or heat-resistant non-metal material.

4. The three-dimensional heat conducting structure (200) according to one of claims 1 to 3, wherein the soldered welding ring (17) stays between the vapor chamber (10) and the heat pipe (20) without overflowing to the interior of the vapor chamber (10).

5. The three-dimensional heat conducting structure (200) according to one of claims 1 to 4, wherein the welding ring (17) encloses the rim (13) before being soldered.

6. The three-dimensional heat conducting structure (200) according to one of claims 1 to 5, wherein a secure bond (16) is formed between the rim (13) and the heat pipe (20) after the laser welding is applied solely on the gaps (15) between the heat pipe (20) and the rim (13).

7. The three-dimensional heat conducting structure (200) according to one of claims 1 to 6, wherein the rim (13) is formed around a periphery of the through hole (12) and is protruded from an outer surface of the vapor chamber (10).

8. The three-dimensional heat conducting structure (200) according to one of claims 1 to 7, wherein the rim (13) is welded to the surface of the vapor chamber (10), surrounding the periphery of the through hole (12).

9. A manufacturing method of a three-dimensional heat conducting structure (200), comprising:
a step (102) of forming a vapor chamber (10) that includes a casing (11) with at least one through hole (12);
a step (104) of forming at least one heat pipe (20) that has an open end (21), and inserting the open end (21) into the through hole (12) so that the heat pipe (20) and vapor chamber (10) are in fluid communication;
a step (106) of applying a laser welding process to gaps (15) between the heat pipe (20) and a rim (13);
a step (108) of placing a welding ring (17) on a joint position of the heat pipe (20) and the vapor chamber (10) so that the welding ring (17) can enclose the rim (13); and
a step (110) of applying a welding process to solder the welding ring (17) to secure the connection between the heat pipe (20) and the vapor chamber (10).

10. The manufacturing method of a three-dimensional heat conducting structure (200) according to claim 9, wherein the rim (13) is formed around a periphery of the through hole (12) and is protruded from an outer surface of the vapor chamber (10).

11. The manufacturing method of a three-dimensional heat conducting structure (200) according to claim 9 or 10, wherein the rim (13) is welded to the surface of the vapor chamber (10), surrounding the periphery of the through hole (12).

12. The manufacturing method of a three-dimensional heat conducting structure (200) according to one of claims 9 to 11, wherein the welding ring (17) is sheathed on the heat pipe (20) and disposed on the casing (11).

13. The manufacturing method of a three-dimensional heat conducting structure (200) according to one of claims 9 to 12, wherein the welding ring (17) encloses the rim (13) before being soldered.

14. The manufacturing method of a three-dimensional heat conducting structure (200) according to one of claims 9 to 13, wherein the vapor chamber (10) further includes a capillary structure and a cooling fluid that are arranged in the interior of the casing (11).

15. The manufacturing method of a three-dimensional heat conducting structure (200) according to one of claims 9 to 14, wherein the welding ring (17) is made of metal, alloy or heat-resistant non-metal material.

16. The manufacturing method of a three-dimensional heat conducting structure (200) according to one of claims 9, to 15 wherein the soldered welding ring (17) stays between the vapor chamber (10) and the heat pipe (20) without overflowing to the interior of the vapor chamber (10).

17. The manufacturing method of a three-dimensional heat conducting structure (200) according to one of claims 9 to 16, wherein the laser welding is applied solely on the gaps (15) between the heat pipe (20) and the rim (13).

## Patentansprüche

1. Eine dreidimensionale Wärmeleitstruktur (200), umfassend:
eine Dampfkammer (10) mit einem Gehäuse (11) und mindestens einem Durchgangsloch (12), das an dem Gehäuse (11) ausgebildet ist und in Fluidverbindung mit dem Inneren des Gehäuses (11) steht;
mindestens ein Wärmerohr (20) mit einem offenen Ende (21), welches in das Durchgangsloch (12) eingeführt ist und in Fluidverbindung mit dem Inneren des Gehäuses (11) steht; und
einen Rand (13), der an einer Außenfläche der Dampfkammer (10) angeordnet ist, wobei
Spalten (15) zwischen dem Rand (13) und dem Wärmerohr (20) durch Laserschweißen abgedichtet sind, und
ein Schweißring (17) angelötet ist, um die Verbindung zwischen dem Wärmerohr (20) und der Dampfkammer (10) zusätzlich zu sichern.

2. Die dreidimensionale Wärmeleitstruktur (200) nach Anspruch 1, wobei die Dampfkammer (10) ferner eine Kapillarstruktur und ein Kühlfluid umfasst, die im Inneren des Gehäuses (11) angeordnet sind.

3. Die dreidimensionale Wärmeleitstruktur (200) nach Anspruch 1 oder 2, wobei der Schweißring (17) aus Metall, einer Legierung oder einem hitzebeständigen nichtmetallischen Material besteht.

4. Die dreidimensionale Wärmeleitstruktur (200) nach einem der Ansprüche 1 bis 3, wobei der gelötete Schweißring (17) zwischen der Dampfkammer (10) und dem Wärmerohr (20) verbleibt, ohne in das Innere der Dampfkammer (10) hineinzulaufen.

5. Die dreidimensionale Wärmeleitstruktur (200) nach einem der Ansprüche 1 bis 4, wobei der Schweißring (17) vor dem Löten den Rand (13) umschließt.

6. Die dreidimensionale Wärmeleitstruktur (200) gemäß einem der Ansprüche 1 bis 5, wobei zwischen dem Rand (13) und dem Wärmerohr (20) eine feste Verbindung (16) hergestellt wird, nachdem das Laserschweißen ausschließlich an den Spalten (15) zwischen dem Wärmerohr (20) und dem Rand (13) durchgeführt wurde.

7. Die dreidimensionale Wärmeleitstruktur (200) gemäß einem der Ansprüche 1 bis 6, wobei der Rand (13) um den Umfang des Durchgangslochs (12) herum ausgebildet ist und aus einer Außenfläche der Dampfkammer (10) herausragt.

8. Die dreidimensionale Wärmeleitstruktur (200) gemäß einem der Ansprüche 1 bis 7, wobei der Rand (13) an die Oberfläche der Dampfkammer (10) geschweißt ist und den Umfang des Durchgangslochs (12) umgibt.

9. Ein Verfahren zur Herstellung einer dreidimensionalen Wärmeleitstruktur (200), umfassend:
einen Schritt (102) zum Ausbilden einer Dampfkammer (10), welche ein Gehäuse (11) mit mindestens einem Durchgangsloch (12) umfasst;
einen Schritt (104) zum Ausbilden mindestens eines Wärmerohrs (20), welches ein offenes Ende (21) aufweist, und zum Einführen des offenen Endes (21) in das Durchgangsloch (12), so dass das Wärmerohr (20) und die Dampfkammer (10) in Fluidverbindung stehen;
einen Schritt (106) des Anwendens eines Laserschweißverfahrens auf Spalte (15) zwischen dem Wärmerohr (20) und einem Rand (13);
einen Schritt (108) des Anbringens eines Schweißrings (17) an einer Verbindungsstelle zwischen dem Wärmerohr (20) und der Dampfkammer (10), sodass der Schweißring (17) den Rand (13) umschließen kann; und
einen Schritt (110) des Anwendens eines Schweißverfahrens zum Löten des Schweißrings (17), um die Verbindung zwischen dem Wärmerohr (20) und der Dampfkammer (10) zu sichern.

10. Das Verfahren zur Herstellung einer dreidimensionalen Wärmeleitstruktur (200) nach Anspruch 9, wobei der Rand (13) um den Umfang des Durchgangslochs (12) herum ausgebildet ist und aus einer Außenfläche der Dampfkammer (10) herausragt.

11. Das Verfahren zur Herstellung einer dreidimensionalen Wärmeleitstruktur (200) gemäß Anspruch 9 oder 10, wobei der Rand (13) an die Oberfläche der Dampfkammer (10) geschweißt ist und den Umfang des Durchgangslochs (12) umgibt.

12. Das Verfahren zur Herstellung einer dreidimensionalen wärmeleitenden Struktur (200) gemäß einem der Ansprüche 9 bis 11, wobei der Schweißring (17) auf das Wärmerohr (20) aufgeschoben und auf dem Gehäuse (11) angeordnet ist.

13. Das Verfahren zur Herstellung einer dreidimensionalen Wärmeleitstruktur (200) gemäß einem der Ansprüche 9 bis 12, wobei der Schweißring (17) den Rand (13) umschließt, bevor er verlötet wird.

14. Das Verfahren zur Herstellung einer dreidimensionalen wärmeleitenden Struktur (200) gemäß einem der Ansprüche 9 bis 13, wobei die Dampfkammer (10) ferner eine Kapillarstruktur und ein Kühlfluid umfasst, die im Inneren des Gehäuses (11) angeordnet sind.

15. Das Verfahren zur Herstellung einer dreidimensionalen wärmeleitenden Struktur (200) gemäß einem der Ansprüche 9 bis 14, wobei der Schweißring (17) aus Metall, einer Legierung oder einem hitzebeständigen nichtmetallischen Material besteht.

16. Das Verfahren zur Herstellung einer dreidimensionalen wärmeleitenden Struktur (200) gemäß einem der Ansprüche 9 bis 15, wobei der gelötete Schweißring (17) zwischen der Dampfkammer (10) und dem Wärmerohr (20) verbleibt, ohne in das Innere der Dampfkammer (10) überzulaufen.

17. Das Verfahren zur Herstellung einer dreidimensionalen Wärmeleitstruktur (200) gemäß einem der Ansprüche 9 bis 16, wobei das Laserschweißen ausschließlich an den Spalten (15) zwischen dem Wärmerohr (20) und dem Rand (13) angewendet wird.

## Revendications

1. Structure conductrice de chaleur tridimensionnelle (200), comprenant :
une chambre à vapeur (10) ayant un boîtier (11) et au moins un trou traversant (12), qui est formé sur le boîtier (11) et est en communication fluidique avec un intérieur du boîtier (11) ;
au moins un tuyau de chaleur (20) ayant une extrémité ouverte (21) qui est insérée dans le trou traversant (12) et est en communication fluidique avec l'intérieur du boîtier (11) ; et
un rebord (13) qui est disposé sur une surface extérieure de la chambre à vapeur (10), dans laquelle
un anneau de soudure (17) est brasé pour sécuriser davantage la connexion entre le tuyau de chaleur (20) et la chambre à vapeur (10), la structure conductrice de chaleur tridimensionnelle étant **caractérisée en ce que** des espaces (15) entre le rebord (13) et le tuyau de chaleur (20) sont scellés par soudure laser.

2. Structure conductrice de chaleur tridimensionnelle (200) selon la revendication 1, dans laquelle la chambre à vapeur (10) comporte en outre une structure capillaire et un fluide de refroidissement qui sont disposés dans l'intérieur du boîtier (11).

3. Structure conductrice de chaleur tridimensionnelle (200) selon la revendication 1 ou 2, dans laquelle l'anneau de soudure (17) est constitué de métal, alliage ou matériau non métallique résistant à la chaleur.

4. Structure conductrice de chaleur tridimensionnelle (200) selon l'une des revendications 1 à 3, dans laquelle l'anneau de soudure (17) brasé reste entre la chambre à vapeur (10) et le tuyau de chaleur (20) sans déborder vers l'intérieur de la chambre à vapeur (10).

5. Structure conductrice de chaleur tridimensionnelle (200) selon l'une des revendications 1 à 4, dans laquelle l'anneau de soudure (17) enferme le rebord (13) avant d'être brasé.

6. Structure conductrice de chaleur tridimensionnelle (200) selon l'une des revendications 1 à 5, dans laquelle une liaison de sécurité (16) est formée entre le rebord (13) et le tuyau de chaleur (20) après l'application de la soudure laser uniquement sur les espaces (15) entre le tuyau de chaleur (20) et le rebord (13).

7. Structure conductrice de chaleur tridimensionnelle (200) selon l'une des revendications 1 à 6, dans laquelle le rebord (13) est formé autour d'une périphérie du trou traversant (12) et fait saillie depuis une surface extérieure de la chambre à vapeur (10).

8. Structure conductrice de chaleur tridimensionnelle (200) selon l'une des revendications 1 à 7, dans laquelle le rebord (13) est soudé à la surface de la chambre à vapeur (10), en entourant la périphérie du trou traversant (12).

9. Procédé de fabrication d'une structure conductrice de chaleur tridimensionnelle (200), comprenant :
une étape (102) consistant à former une chambre à vapeur (10) qui comporte un boîtier (11) avec au moins un trou traversant (12) ;
une étape (104) consistant à former au moins un tuyau de chaleur (20) qui a une extrémité ouverte (21), et à insérer l'extrémité ouverte (21) dans le trou traversant (12) de sorte que le tuyau de chaleur (20) et la chambre à vapeur (10) sont en communication fluidique ;
une étape (106) consistant à appliquer un processus de soudure laser à des espaces (15) entre le tuyau de chaleur (20) et un rebord (13) ;
une étape (108) consistant à placer un anneau de soudure (17) sur une position de jonction du tuyau de chaleur (20) et de la chambre à vapeur (10) de sorte que l'anneau de soudure (17) peut enfermer le rebord (13) ; et
une étape (110) consistant à appliquer un processus de soudure pour braser l'anneau de soudure (17) afin de sécuriser la connexion entre le tuyau de chaleur (20) et la chambre à vapeur (10).

10. Procédé de fabrication d'une structure conductrice de chaleur tridimensionnelle (200) selon la revendication 9, dans lequel le rebord (13) est formé autour d'une périphérie du trou traversant (12) et fait saillie depuis une surface extérieure de la chambre à vapeur (10).

11. Procédé de fabrication d'une structure conductrice de chaleur tridimensionnelle (200) selon la revendication 9 ou 10, dans lequel le rebord (13) est soudé à la surface de la chambre à vapeur (10), en entourant la périphérie du trou traversant (12).

12. Procédé de fabrication d'une structure conductrice de chaleur tridimensionnelle (200) selon l'une des revendications 9 à 11, dans lequel l'anneau de soudure (17) est gainé sur le tuyau de chaleur (20) et disposé sur le boîtier (11).

13. Procédé de fabrication d'une structure conductrice de chaleur tridimensionnelle (200) selon l'une des revendications 9 à 12, dans lequel l'anneau de soudure (17) enferme le rebord (13) avant d'être brasé.

14. Procédé de fabrication d'une structure conductrice de chaleur tridimensionnelle (200) selon l'une des revendications 9 à 13, dans lequel la chambre à vapeur (10) comporte en outre une structure capillaire et un fluide de refroidissement qui sont disposés dans l'intérieur du boîtier (11).

15. Procédé de fabrication d'une structure conductrice de chaleur tridimensionnelle (200) selon l'une des revendications 9 à 14, dans lequel l'anneau de soudure (17) est constitué de métal, alliage ou matériau non métallique résistant à la chaleur.

16. Procédé de fabrication d'une structure conductrice de chaleur tridimensionnelle (200) selon l'une des revendications 9 à 15, dans lequel l'anneau de soudure (17) brasé reste entre la chambre à vapeur (10) et le tuyau de chaleur (20) sans déborder vers l'intérieur de la chambre à vapeur (10).

17. Procédé de fabrication d'une structure conductrice de chaleur tridimensionnelle (200) selon l'une des revendications 9 à 16, dans lequel la soudure laser est appliquée uniquement sur les espaces (15) entre le tuyau de chaleur (20) et le rebord (13).
